# EUROPÄISCHE PATENTSCHRIFT

(11) **EP 1 906 496 B1**
(45) Veröffentlichungstag und Bekanntmachung des Hinweises auf die Patenterteilung: **06.01.2010**
(21) Anmeldenummer: 07115952.9
(22) Anmeldetag: 07.09.2007
(51) Int. Cl.: H01S 5/024, H01S 5/183, H01S 5/40

(54) **Halbleiterlaser und Verfahren zur Herstellung eines solchen**
Semiconductor laser and method for manufacturing the same
Laser semi-conducteur et son procédé de fabrication

(30) Priorität: 29.09.2006 DE 102006046295; 11.01.2007 DE 102007001743
(43) Veröffentlichungstag der Anmeldung: 02.04.2008
(73) Patentinhaber: OSRAM Opto Semiconductors GmbH, 93055 Regensburg (DE)
(72) Erfinder: Müller, Martin, 93128 Regenstauf (DE); König, Harald, 93170 Bernhardswald (DE); Philippens, Marc, 93049 Regensburg (DE)
(74) Vertreter: Epping - Hermann - Fischer

(56) Entgegenhaltungen:
- US-A1- 2005 087 735
- US-A1- 2005 116 336
- US-A1- 2005 199 894
- US-A1- 2006 029 117

## Beschreibung

Diese Patentanmeldung beansprucht die Priorität der deutschen Patentanmeldungen 102006046295.5 und 102007001743.1.

Die Erfindung betrifft einen Halbleiterlaser und ein Verfahren zur Herstellung eines solchen.

Die Emissionseigenschaften eines Halbleiterlasers hängen sehr stark von der Temperatur im aktiven Bereich des Lasers ab. Eine Erhöhung der Temperatur des aktiven Bereichs durch Verlustwärme, die im Betrieb des Halbleiterlasers im aktiven Bereich entsteht, führt zu einer unzureichenden Emissionscharakteristik des Halbleiterlasers.

Die Druckschrift US 2005/0087735 A1 offenbart eine Laservorrichtung, bei der eine dünne Schicht mit Kohlenstoff-Nanoröhren zwischen einem Halbleiterkörper und einem Kühlelement angeordnet ist.

Die Druckschrift US 2006/0029117 A1 betrifft ein Lasermodul mit Elektroden und Laserchips, wobei die Elektroden Kopplungsmittel haben, welche zwischen den Elektroden und den Laserchips Kohlenstoff-Nanoröhren umfassen.

Es ist daher eine Aufgabe der Erfindung, einen Halbleiterlaser anzugeben, bei dem Verlustwärme besonders effizient vom aktiven Bereich abtransportiert wird.

Diese Aufgabe wird durch einen Halbleiterlaser gemäß Anspruch 1 und durch ein Verfahren zum Herstellen eines Halbleiterlasers gemäß Anspruch 27 gelöst.

Vorteilhafte Ausführungsformen und Weiterbildungen des Halbleiterlasers bzw. des Verfahrens sind jeweils in den abhängigen Ansprüchen angegeben, deren Offenbarungsgehalt hiermit explizit in die Beschreibung aufgenommen wird.

Ein Halbleiterlaser gemäß der Erfindung umfasst insbesondere eine laseraktive Halbleiterschichtenfolge und eine Wärmeleitschicht, die Kohlenstoff-Nanoröhren aufweist und die auf der Halbleiterschichtenfolge angeordnet ist. Vorzugsweise ist die Wärmeleitschicht auf einer ersten Hauptfläche der Halbleiterschichtenfolge angeordnet. Die Wärmeleitschicht bedeckt also vorzugsweise die Halbleiterschichtenfolge in Draufsicht auf die erste Hauptfläche stellenweise oder vollständig. Die Haupterstreckungsebenen der Halbleiterschichtenfolge und der Wärmeleitschicht sind bevorzugt zueinander parallel, sodass die erste Hauptfläche der Halbleiterschichtenfolge und eine Hauptfläche der Wärmeleitschicht einander zugewandt sind und/oder aneinander angrenzen.

Die Ausdrücke "auf der Halbleiterschichtenfolge angeordnet" und "auf einer ersten Hauptfläche der Halbleiterschichtenfolge angeordnet", umfassen dabei sowohl Ausführungsformen, bei denen die Wärmeleitschicht direkt an die Halbleiterschichtenfolge angrenzt, als auch solche Ausführungsformen, bei denen mindestens eine weitere Schicht zwischen der Halbleiterschichtenfolge und der Wärmeleitschicht angeordnet ist.

Die laseraktive Halbleiterschichtenfolge weist einen aktiven Bereich, insbesondere eine aktive Schicht, auf, die zur Erzeugung von Laserstrahlung vorgesehen ist.

Der aktive Bereich umfasst vorzugsweise einen laseraktiven pn-Übergang. Der laseraktive pn-Übergang weist beispielsweise eine Doppelheterostruktur, einen Einfach-Quantentopf (SQW) oder eine Mehrfach-Quantentopfstruktur (MQW) zur Strahlungserzeugung auf. Die Bezeichnung Quantentopfstruktur beinhaltet hierbei keine Angabe über die Dimensionalität der Quantisierung. Sie umfasst somit u. a. Quantentröge, Quantendrähte und Quantenpunkte und jede Kombination dieser Strukturen. Beispiele für MQW-Strukturen sind in den Druckschriften WO 01/39282, US 5,831,277, US 6,172,382 B1 und US 5,684,309 beschrieben.

Im Betrieb des Halbleiterlasers erzeugte Laserstrahlung wird entweder durch eine Flanke der laseraktiven Halbleiterschichtenfolge emittiert (Kantenemitter) oder durch eine Hauptfläche der Halbleiterschichtenfolge (Oberflächenemitter). Der aktive Bereich der laseraktiven Halbleiterschichtenfolge wird im Betrieb des Halbleiterlasers elektrisch gepumpt, also durch Einprägen eines elektrischen Stroms in die laseraktive Halbleiterschichtenfolge, und/oder er wird optisch gepumpt, also durch Bestrahlen der laseraktiven Halbleiterschichtenfolge mit elektromagnetischer Strahlung. Der elektrische Strom und/oder die elektromagnetische Strahlung sind dabei zweckmäßigerweise dazu geeignet, eine Besetzungsinversion im aktiven Bereich zu erzeugen.

Bei einer vorteilhaften Ausführungsform umfasst die laseraktive Halbleiterschichtenfolge eine Pumpstrahlungsquelle, die geeignet ist, den aktiven Bereich optisch zu pumpen.

Beispiele für laseraktive Halbleiterschichtenfolgen und für Verfahren zur deren Herstellung sind in den Druckschriften WO 02/49168 A2 und WO 02/067393 A1 beschrieben.

Die in der Wärmeleitschicht enthaltenen Kohlenstoff-Nanoröhren ("carbon nanotubes") sind röhrenförmige, in der Regel mikroskopisch kleine Gebilde, die Kohlenstoff enthalten oder daraus bestehen. Wie bei Graphit haben die Kohlenstoffatome einer Kohlenstoff-Nanoröhre in der Regel drei nächste Kohlenstoffnachbarn. Die Kohlenstoffatome bilden eine wabenartige Struktur, die üblicherweise vorwiegend oder ausschließlich sechseckige Grundeinheiten aufweist, in deren Ecken die Kohlenstoffatome sitzen. Während bei Graphit die wabenartige Struktur sich in einer Ebene erstreckt, ist sie bei Kohlenstoff-Nanoröhren zu einer Röhre gebogen, die in der Regel einen kreisförmigen oder elliptischen Querschnitt aufweist.

Bei einer Ausführungsform sind zumindest einige, vorzugsweise jedoch ein Großteil oder alle, der Kohlenstoff-Nanoröhren auf mindestens einer Seite geschlossen. Alternativ oder zusätzlich können sie auch durch Trennschichten, die Kohlenstoffatome enthalten und die im Wesentlichen parallel zur Grundfläche der Kohlenstoff-Nanoröhre verlaufen, in eine Mehrzahl von Segmenten untergliedert sein. Beispielsweise sind die Trennschichten Monolagen aus Kohlenstoffatomen.

Die Wärmeleitschicht enthält einwandige Kohlenstoff-Nanoröhren, mehrwandige Kohlenstoff-Nanoröhren und/oder Kohlenstoff-Nanoröhren mit Wänden, die in Draufsicht auf die Grundfläche der Kohlenstoff-Nanoröhre spiralförmig sind.

Vorzugsweise besteht die Wärmeleitschicht praktisch ausschließlich aus Kohlenstoff. Obwohl die Wärmeleitschicht vorzugsweise im Wesentlichen aus Kohlenstoff besteht, kann es - beispielsweise bedingt durch das Herstellungsverfahren - vorkommen, dass der Kohlenstoff nicht ausschließlich in Form von Nanoröhren, sondern z. B. auch als Graphit, als Fullerene und/oder amorph in der Wärmeleitschicht vorliegt. Bevorzugt weist jedoch ein möglichst großer Anteil der Wärmeleitschicht Kohlenstoff-Nanoröhren auf. Beispielsweise ist der Anteil der von Kohlenstoff-Nanoröhren bedeckten Fläche in Draufsicht auf eine Hauptfläche der Wärmeleitschicht größer oder gleich 30 %, bevorzugt größer oder gleich 50 %.

Die Dicke der Wände beträgt beispielsweise zwischen 1 und 15 nm, vorzugsweise zwischen 5 und 10 nm. Der Außendurchmesser der Grundfläche einer Kohlenstoff-Nanoröhre, anders ausgedrückt der Querschnitt der Kohlenstoff-Nanoröhre, beträgt beispielsweise zwischen 5 und 50 nm, vorzugsweise zwischen 15 und 25 nm. Die Länge einer Kohlenstoff-Nanoröhre beträgt beispielsweise zwischen 1 µm und 500 µm. Vorzugsweise hat eine Mehrzahl der Kohlenstoff-Nanoröhren eine Länge zwischen 1 und 20 µm, vorzugsweise zwischen 3 und 10 µm. Besonders bevorzugt hat die Wärmeleitschicht eine Dicke, die zumindest im Wesentlichen der Länge oder einer mittleren Länge der Kohlenstoff-Nanoröhren entspricht. Bei einer alternativen Ausführungsform entspricht die Dicke der Wärmeleitschicht einem ganzzahligen Vielfachen der Länge beziehungsweise der mittleren Länge der Kohlenstoff-Nanoröhren.

Die Wärmeleitschicht, die Kohlenstoff-Nanoröhren aufweist, hat mit Vorteil eine besonders hohe Wärmeleitfähigkeit. Die in der laseraktiven Halbleiterschichtenfolge, insbesondere im aktiven Bereich, erzeugte Verlustwärme wird so besonders effektiv abgeführt. Insbesondere ist die Wärmeleitfähigkeit gegenüber konventionellen Wärmeleitschichten, die beispielsweise Gold oder Diamant aufweisen, vorteilhafterweise deutlich erhöht. Beispielsweise ist die Wärmeleitfähigkeit der Wärmeleitschicht mit Kohlenstoff-Nanoröhren größer oder gleich 3000 W/mK, vorzugsweise größer oder gleich 4000 W/mK. Bei einer besonders vorteilhaften Ausführungsform beträgt sie zwischen 4000 und 6000 W/mK. Die Wärmeleitfähigkeit ist also gegenüber derjenigen von Gold bzw. Diamant, welche in konventionellen Wärmeleitschichten verwendet werden und die eine Wärmeleitfähigkeit von 312 bzw. 2000 W/mK aufweisen, mit Vorteil stark erhöht.

Die Wärmeleitschicht, die Kohlenstoff-Nanoröhren aufweist, vergrößert zudem vorteilhafterweise die Fläche, über die Verlustwärme von dem Halbleiterlaser abgegeben wird besonders effektiv. Die Verlustwärme entsteht bei dem Halbleiterlaser in der Regel in einem räumlich eng begrenzten Bereich. Insbesondere entspricht dieser Bereich im Wesentlichen dem Bereich, in dem die Laserstrahlung erzeugt wird und/oder in dem der Halbleiterschichtenfolge elektrisch und/oder optisch gepumpt wird. In Draufsicht auf eine Hauptfläche der laseraktiven Halbleiterschichtenfolge wird die Laserstrahlung und damit auch die Verlustwärme daher nur an einer Stelle, beispielsweise einem Streifen, oder an einigen Stellen der laseraktiven Halbleiterschichtenfolge erzeugt. Die Wärmeleitschicht verteilt vorteilhafterweise die Verlustwärme auf einen möglichst großen Teil der Fläche, bevorzugt auf die gesamte Fläche, der Wärmeleitschicht. So wird mit Vorteil der Wärmewiderstand, der umgekehrt proportional zur Fläche ist, verringert. Beispielsweise wird dadurch die Verlustwärme besonders effizient von dem Halbleiterlaser an die Umgebung abgegeben. So weist der Halbleiterlaser insbesondere eine besonders hohe Effizienz und emittiert im Betrieb einen Laserstrahl mit besonders guter Strahlqualität.

Bei einer vorteilhaften Ausführungsform sind zumindest einige, vorzugsweise jedoch ein Großteil oder alle, der Kohlenstoff-Nanoröhren teilweise oder vollständig mit einem Füllmaterial gefüllt. Als Füllmaterialien sind beispielsweise Silber, Blei und Edelgase wie Helium, Neon und/oder Argon denkbar. Die Wärmeleitfähigkeit der Kohlenstoff-Nanoröhren mit Füllmaterial ist mit Vorteil weiter erhöht.

Bei einer vorteilhaften Ausführungsform enthält die Wärmeleitschicht eine erste Mehrzahl von Kohlenstoff-Nanoröhren, die im Wesentlichen parallel zueinander ausgerichtet sind. Beispielsweise verlaufen die Kohlenstoff-Nanoröhren der ersten Mehrzahl von Kohlenstoff-Nanoröhren im Wesentlichen parallel zur Haupterstreckungsebene der Wärmeleitschicht. Alternativ können sie auch in einem Winkel zur Haupterstreckungsebene der Wärmeleitschicht verlaufen. Beispielsweise verlaufen sie im Wesentlichen senkrecht zur Haupterstreckungsebene der Wärmeleitschicht.

Vorteilhafterweise kann mit einer Wärmeleitschicht, die definiert zueinander ausgerichtete Kohlenstoff-Nanoröhren aufweist, eine besonders hohe Wärmeleitfähigkeit erzielt werden.

Bei einer weiteren vorteilhaften Ausführungsform enthält die Wärmeleitschicht eine zweite Mehrzahl von Kohlenstoff-Nanoröhren, die im Wesentlichen parallel zueinander und in einem Winkel, beispielsweise senkrecht, zu der Richtung ausgerichtet sind, entlang welcher die erste Mehrzahl von Kohlenstoff-Nanoröhren verläuft. Analog zu der ersten Mehrzahl von Kohlenstoff-Nanoröhren kann die zweite Mehrzahl von Kohlenstoff-Nanoröhren im Wesentlichen parallel oder in einem Winkel, insbesondere im Wesentlichen senkrecht, zur Haupterstreckungsebene der laseraktiven Halbleiterschichtenfolge verlaufen.

Alternativ dazu kann die Ausrichtung der Kohlenstoff-Nanoröhren zufällig verteilt sein. Bevorzugt weist jedoch ein Teil, insbesondere ein Großteil oder alle, der Kohlenstoff-Nanoröhren eine definierte Ausrichtung auf, anders ausgedrückt gehört bevorzugt ein Teil, insbesondere ein Großteil oder alle, der Kohlenstoff-Nanoröhren zu der ersten Mehrzahl beziehungsweise zu der ersten oder zu der zweiten Mehrzahl von Kohlenstoff-Nanoröhren. So kann mit Vorteil die Richtung, entlang der in der Wärmeleitschicht eine besonders gute Wärmeleitung erfolgt, definiert eingestellt werden.

Beispielsweise enthält die Wärmeleitschicht eine erste Schicht, die die erste Mehrzahl von Kohlenstoff-Nanoröhren aufweist, und eine zweite Schicht, die die zweite Mehrzahl von Kohlenstoff-Nanoröhren aufweist. Die erste und die zweite Schicht grenzen beispielsweise aneinander an oder sie sind voneinander beabstandet. Vorzugsweise weist die erste Schicht die zweite Mehrzahl von Kohlenstoff-Nanoröhren nicht auf und/oder die zweite Schicht weist die erste Mehrzahl von Kohlenstoff-Nanoröhren nicht auf. Mit anderen Worten enthält die erste Schicht vorzugsweise im Wesentlichen Kohlenstoff-Nanoröhren, die in einer ersten Richtung verlaufen, und die zweite Schicht enthält im Wesentlichen Kohlenstoff-Nanoröhren, die in einer zweiten Richtung verlaufen, wobei die zweite Richtung von der ersten Richtung verschieden ist.

Bei einer Ausführungsform ist eine Hauptfläche der laseraktiven Halbleiterschichtenfolge vollständig oder zumindest praktisch vollständig von der Wärmeleitschicht bedeckt. Bei einer anderen Ausführungsform bedeckt die Wärmeleitschicht eine Hauptfläche der laseraktiven Halbleiterschichtenfolge nur stellenweise. Anders ausgedrückt ist bei dieser Ausführungsform die Wärmeleitschicht strukturiert. Die Strukturierung der Wärmeleitschicht erfolgt beispielsweise bei der Herstellung der Wärmeleitschicht, etwa mittels Abscheidung der Wärmeleitschicht durch eine Schattenmaske hindurch. Alternativ kann eine vollflächig hergestellte Wärmeleitschicht nachträglich strukturiert werden. Beispielsweise umfasst die nachträgliche Strukturierung einen Photolithographieprozess.

Bei einer besonders vorteilhaften Ausführungsform ist die Wärmeleitschicht elektrisch leitfähig. Insbesondere sind die Kohlenstoff-Nanoröhren, die in der Wärmeleitschicht enthalten sind, oder ist zumindest ein Großteil dieser Kohlenstoff-Nanoröhren elektrisch leitfähig. Mit Vorteil weist die Wärmeleitschicht also sowohl eine gute Wärmeleitfähigkeit als auch eine gute elektrische Leitfähigkeit auf.

Eine metallische Schicht ist zwischen der laseraktiven Halbleiterschichtenfolge und der Wärmeleitschicht angeordnet.

Die metallische Schicht enthält mindestens ein Metall oder besteht aus einem Metall. Beispielsweise weist die metallische Schicht Ag, Au, Pt, Ti, W und/oder Fe auf. Die metallische Schicht weist bei einer vorteilhaften Ausführungsform eine Mehrschichtstruktur auf. Beispielsweise umfasst sie eine Metallschicht, die zum Beispiel Ag aufweist, eine Diffusionsbarriere, die zum Beispiel TiWN und/oder Ti/Pt aufweist, und/oder eine weitere Metallschicht, die beispielsweise Fe aufweist.

Vorteilhafterweise wird mit der metallischen Schicht eine besonders homogene Stromeinprägung in die laseraktive Halbleiterschichtenfolge erzielt. Zudem ist die Wärmeleitschicht, die Kohlenstoff-Nanoröhren aufweist, auf der metallischen Schicht besonders einfach herstellbar, beispielsweise mittels einer chemischen Gasphasenabscheidung. Weiterhin wird mit der metallischen Schicht vorteilhafterweise eine besonders gute thermische Ankopplung der Wärmeleitschicht an die Halbleiterschichtenfolge erzielt.

Die Diffusionsbarriere verhindert oder verringert beispielsweise mit Vorteil das Eindringen eines Lötmetalls durch die metallische Schicht in die laseraktive Halbleiterschichtenfolge.

Bevorzugt grenzt die Wärmeleitschicht an die metallische Schicht an. Besonders bevorzugt grenzt die metallische Schicht zusätzlich oder alternativ an die laseraktive Halbleiterschichtenfolge an. Die Dicke der metallischen Schicht ist beispielsweise kleiner oder gleich 10 µm. Bei einer Ausführungsform ist sie kleiner oder gleich 50 nm, beispielsweise etwa 10 nm.

Bei einer alternativen Ausführungsform grenzt die Wärmeleitschicht direkt an die laseraktive Halbleiterschichtenfolge an.

Mit Vorteil ist die Wärmeleitschicht also direkt auf der laseraktiven Halbleiterschichtenfolge aufgebracht oder weist nur einen geringen Abstand von dieser auf. So wird mit Vorteil die in der laseraktiven Halbleiterschichtenfolge im Betrieb des Halbleiterlasers erzeugte Verlustwärme besonders nahe an der laseraktiven Halbleiterschichtenfolge auf eine große Fläche verteilt und besonders effizient von der laseraktiven Halbleiterschichtenfolge weg geleitet. Die Temperatur des aktiven Bereichs wird dadurch besonders niedrig gehalten.

Bei einer vorteilhaften Ausführungsform ist eine weitere metallische Schicht der von der laseraktiven Halbleiterschichtenfolge abgewandten Hauptfläche der Wärmeleitschicht benachbart. Beispielsweise stellt die weitere metallische Schicht eine elektrischen Anschlussschicht dar, mittels welcher der laseraktiven Halbleiterschichtenfolge insbesondere im Betrieb ein elektrischer Strom zugeführt wird, der insbesondere zum elektrischen Pumpen des Halbleiterlasers vorgesehen ist.

Bei einer anderen Ausführungsform weist der Halbleiterlaser eine Mehrzahl von Wärmeleitschichten, die Kohlenstoff-Nanoröhren aufweisen, auf. Beispielsweise weist er eine alternierende Folge von metallischen Schichten und Wärmeleitschichten auf. So wird vorteilhafterweise eine besonders effiziente Wärmeabfuhr von der laseraktiven Halbleiterschichtenfolge und insbesondere eine besonders großflächige Verteilung der Verlustwärme, sowie eine besonders homogene Stromeinprägung in die laseraktive Halbleiterschichtenfolge erzielt.

Bei einer bevorzugten Ausführungsform weist der Halbleiterlaser, insbesondere nachfolgend auf die von der laseraktiven Halbleiterschichtenfolge abgewandte Hauptfläche der Wärmeleitschicht bzw. der Wärmeleitschichten, eine Wärmesenke auf. Die Wärmeleitschicht beziehungsweise die Wärmeleitschichten sind also bevorzugt zwischen der Halbleiterschichtenfolge und der Wärmesenke angeordnet.

Bei dieser Ausführungsform wird die in der laseraktiven Halbleiterschichtenfolge erzeugte Verlustwärme, oder zumindest ein Teil, insbesondere ein Großteil, davon, von der Wärmeleitschicht und ggf. von der metallischen Schicht oder den metallischen Schichten zu der Wärmesenke transportiert und über diese beispielsweise an die Umgebung abgegeben.

Bevorzugt ist die Wärmesenke mit der laseraktiven Halbleiterschichtenfolge mechanisch stabil verbunden, beispielsweise mittels einer Befestigungsschicht, die bevorzugt ein Lot, etwa mindestens ein Lötmetall wie Au, AuSn, Pd, In und/oder Pt, oder einen Klebstoff enthält oder daraus besteht.

Bei einer weiteren Ausführungsform umfasst der Halbleiterlaser mindestens einen Bragg-Reflektor (DBR, distributed Bragg reflector), der insbesondere eine Folge von dielektrischen, halbleitenden und/oder metallischen Schichten mit alternierend hohem und niedrigem Brechungsindex umfasst. Der Bragg-Reflektor ist bevorzugt monolithisch in die laseraktive Halbleiterschichtenfolge integriert. Beispielsweise ist der Bragg-Reflektor ein Teil eines Resonators des Halbleiterlasers.

Ein erfindungsgemäßes Verfahren zum Herstellen eines Halbleiterlasers weist insbesondere die folgenden Schritte auf:
- Bereitstellen einer laseraktiven Halbleiterschichtenfolge und
- Herstellen einer Wärmeleitschicht, die Kohlenstoff-Nanoröhren aufweist, auf der laseraktiven Halbleiterschichtenfolge.

Das Herstellen der Wärmeleitschicht erfolgt bevorzugt derart, dass die Wärmeleitschicht im Wesentlichen nur Kohlenstoff enthält.

Beispielsweise umfasst das Verfahren zur Herstellung der Wärmeleitschicht eine Gasphasenabscheidung, bevorzugt eine chemische Gasphasenabscheidung (chemical vapor deposition, CVD), mittels welcher die Wärmeleitschicht auf die laseraktive Halbleiterschichtenfolge aufgebracht wird. Bei einer vorteilhaften Ausführungsform wird die Wärmeleitschicht mit einer plasmabasierten chemischen Gasphasenabscheidung hergestellt. Vorzugsweise erfolgt die Gasphasenabscheidung bei einer Temperatur von kleiner oder gleich 350 °C. So wird mit Vorteil eine Beschädigung und/oder Degradation der laseraktiven Halbleiterschichtenfolge beim Herstellen der Wärmeleitschicht verhindert.

Alternativ können die Kohlenstoff-Nanoröhren auch zunächst separat hergestellt und dann als Wärmeleitschicht auf die laseraktive Halbleiterschichtenfolge aufgebracht werden, etwa durch Eintrocknen einer Lösung.

Geeignete Herstellungsverfahren für Kohlenstoff-Nanoröhren sind beispielsweise in den Druckschriften Mi Chen et al., "Preparation of high-yield multi-walled carbon nanotubes by microwave plasma chemical vapor deposition at low temperature", Journal of Materials Science, Vol. 37, Seiten 3561-3567 (2002); Ming-Wei Li et al., "Low-temperature synthesis of carbon nanotubes using corona discharge plasma reaction at atmospheric pressure", Journal of Materials Science Letters, Vol. 22, Seiten 1223-1224 (2003); und Wenzhong Wang et al., "Low temperature solvothermal synthesis of multiwall carbon nanotubes", Nanotechnology, Vol. 16, Seiten 21-23 (2005) beschrieben.

Die Wärmeleitschicht wird bei einer nicht beanspruchten Ausführungsform direkt auf der laseraktiven hergestellt, insbesondere abgeschieden. Vorliegend wird sie auf einer weiteren Schicht, nämlich einer metallischen Schicht, abgeschieden oder anderweitig hergestellt, die auf der laseraktiven Halbeiterschichtenfolge angeordnet ist. Die weitere Schicht wird zum Beispiel in einem zusätzlichen, der Herstellung der Wärmeleitschicht vorhergehenden Prozessschritt auf der laseraktiven Halbleiterschichtenfolge hergestellt.

Eine Befestigung der Wärmeleitschicht auf der laseraktiven Halbleiterschichtenfolge mittels eines Klebers oder Lötmittels ist, beispielsweise im Gegensatz zu einer Wärmeleitschicht aus Diamant, vorteilhafterweise nicht notwendig. Insbesondere ist auch eine Vermischung der Kohlenstoff-Nanoröhren mit einem Matrixmaterial, etwa mit einem Klebstoff, nicht vorgesehen. Beispielsweise da Klebebeziehungsweise Lötstellen in der Regel einen erhöhten Wärmewiderstand aufweisen, wird so mit Vorteil eine besonders gute thermische und/oder elektrische Ankopplung der Wärmeleitschicht und insbesondere der Kohlenstoff-Nanoröhren an die laseraktive Halbleiterschichtenfolge erzielt. Zudem wird die Herstellung des Halbleiterlasers durch den Wegfall des Klebe- beziehungsweise Lötprozesses vereinfacht.

Weitere Vorteile und vorteilhafte Ausführungsformen und Weiterbildungen der Erfindung ergeben sich aus den im Folgenden in Verbindung mit den Figuren 1 bis 3 beschriebenen Ausführungsbeispielen.

Es zeigen:
- Figur 1,: einen schematischen Querschnitt durch einen Halbleiterlaser gemäß einem ersten Ausführungsbeispiel;
- Figur 2,: einen schematischen Querschnitt durch einen Halbleiterlaser gemäß einem zweiten Ausführungsbeispiel;
- Figur 3,: einen schematischen Querschnitt durch einen Halbleiterlaser gemäß einem dritten Ausführungsbeispiel;
- Figur 4,: eine schematische Schnittdarstellung der Wärmeleitschicht des Halbleiterlasers gemäß dem ersten Ausführungsbeispiel;
- Figur 5,: eine schematische Schnittdarstellung einer Wärmeleitschicht gemäß einer Variante des ersten Ausführungsbeispiels; und
- Figur 6,: eine schematische Schnittdarstellung eines Halbleiterlasers gemäß einem vierten Ausführungsbeispiel.

In den Ausführungsbeispielen und Figuren sind gleiche oder gleich wirkende Bestandteile jeweils mit den gleichen Bezugszeichen versehen. Die dargestellten Elemente und deren Größenverhältnisse untereinander sind grundsätzlich nicht als maßstabsgerecht anzusehen, vielmehr können einzelne Elemente, wie z. B. Schichten, zur besseren Darstellbarkeit und/oder zum besseren Verständnis übertrieben groß bzw. dick dargestellt sein.

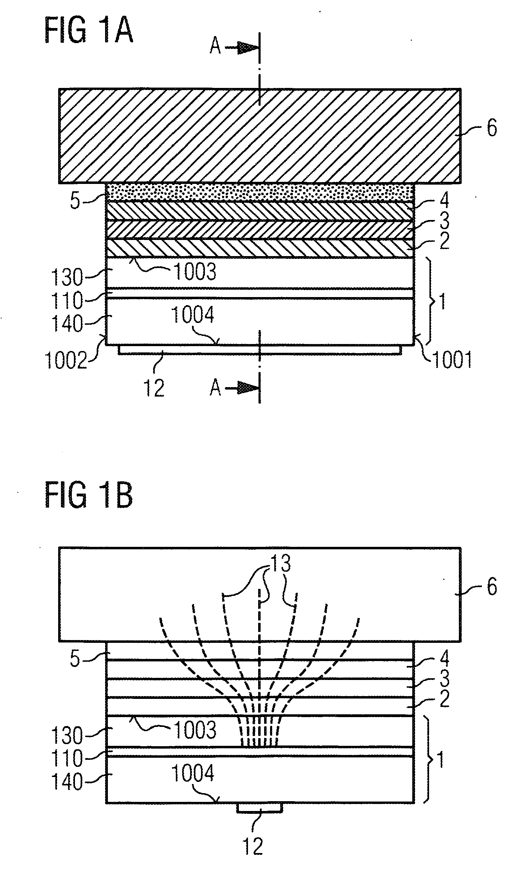

Der Halbleiterlaser gemäß dem in Figur 1 dargestellten ersten Ausführungsbeispiel umfasst eine laseraktive Halbleiterschichtenfolge 1, die eine aktive Schicht 110 enthält.

Als Halbleiter-Materialsysteme für die Halbleiterschichtenfolge 1 sind unter anderem Halbleitermaterialien geeignet, die auf GaAs, InP, InGaAs, AlGaAs, InGaAlAs, InGaP, InGaAsP, InGaAlP oder einer Kombination aus mindestens zwei dieser Materialien basieren.

Beispielsweise bedeutet "Halbleitermaterial, das auf InGaAs basiert" im vorliegenden Zusammenhang, dass die Halbleiterschichtenfolge 1 oder zumindest ein Teil davon, beispielsweise die aktive Schicht 110, ein InGaAs-Halbleitermaterial, vorzugsweise InₙGaₘAs aufweist oder aus diesem besteht, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es beispielsweise ein oder mehrere Dotierstoffe sowie zusätzliche Bestandteile aufweisen. Der Einfachheit halber beinhaltet obige Formel jedoch nur die wesentlichen Bestandteile des Kristallgitters (Al, Ga, As), auch wenn diese teilweise durch geringe Mengen weiterer Stoffe ersetzt sein können. Für die übrigen, oben genannten Halbleitermaterialien gilt dies entsprechend.

Vorliegend basiert die laseraktive Halbleiterschichtenfolge 1 auf einem InGaAs/AlGaAs-Halbleiter-Materialsystem. Die aktive Schicht 110 ist als Mehrfach-Quantentopfstruktur ausgebildet und weist eine Mehrzahl von Quantentöpfen auf, die aus undotiertem InGaAs bestehen. Die aktive Schicht 110 ist zwischen einer n-Mantelschicht 130 und einer p-Mantelschicht 140 angeordnet. Beispielsweise wird mit der n-Mantelschicht 130 und der p-Mantelschicht 140 ein Ladungsträgereinschluss (confinement) erzielt. Alternativ oder zusätzlich stellen die n-Mantelschicht 130 oder ein Teilbereich davon und die p-Mantelschicht 140 oder ein Teilbereich davon vorzugsweise einen Wellenleiter dar, der zur Führung von Laserstrahlung geeignet ist, die im Betrieb des Halbleiterlasers in der aktiven Schicht 110 erzeugt wird.

Bei dem Halbleiterlaser gemäß dem ersten Ausführungsbeispiel handelt es sich um einen Kantenemitter, dessen Flanken 1001, 1002 als Resonator ausgebildet sind. Die im Betrieb erzeugte Laserstrahlung wird durch mindestens eine der Flanken 1001, 1002 ausgekoppelt.

Auf der ersten Hauptfläche 1003 der laseraktiven Halbleiterschichtenfolge 1 ist eine erste metallische Schicht 2 angeordnet. Die erste metallische Schicht 2 dient beispielsweise zur Ladungsträgerinjektion. Sie weist eine hohe elektrische Querleitfähigkeit auf, sodass eine homogene Stromeinprägung in die laseraktive Halbleiterschichtenfolge 1 erzielt wird.

Auf der ersten metallischen Schicht 2 ist eine Wärmeleitschicht 3 abgeschieden, die Kohlenstoff-Nanoröhren 30 enthält. Die Abscheidung erfolgt beispielsweise mit einem Mikrowellenplasma-gestützten CVD-Verfahren bei einer Temperatur von 330 °C oder weniger, vorzugsweise von 300 °C oder weniger. Ein solches Verfahren ist zum Beispiel in der Druckschrift Mi Chen et al., "Preparation of high-yield multi-walled carbon nanotubes by microwave plasma chemical vapor deposition at low temperature", Journal of Materials Science, Vol. 37, Seiten 3561-3567 (2002), grundsätzlich beschrieben.

Auf die Wärmeleitschicht 3 ist eine zweite metallische Schicht 4 aufgebracht, also eine Schicht 4, die ein Metall enthält oder daraus besteht. Die zweite metallische Schicht 4, schützt mit Vorteil die Wärmeleitschicht 3 vor mechanischen Beschädigungen. Zudem wird mit der zweiten metallischen Schicht 4 eine einfache und stabile Befestigung der laseraktiven Halbleiterschichtenfolge 1 an einer Wärmesenke 6 erzielt. Die Vermittlung der Haftung erfolgt hierbei beispielsweise mittels der Befestigungsschicht 5, die ein Lötmetall wie AuSn aufweist oder daraus besteht. Um eine Diffusion des Lötmetalls aus der Befestigungsschicht 5 in die laseraktive Halbleiterschichtenfolge zu verringern oder ganz zu verhindern, umfasst die zweite metallische Schicht 4 vorliegend eine Diffusionsbarriere-Schicht, die aus TiWN besteht. Die zweite metallische Schicht 4 stellt vorliegend auch eine elektrische Anschlussschicht dar.

Die Wärmesenke 6 umfasst beispielsweise eine Metallplatte. Eine besonders effiziente Kühlung wird mit einer Wärmesenke 6 erzielt, die eine Flüssigkeitskühlung, etwa eine Wasserkühlung, aufweist. Beispielsweise enthält die Wärmesenke 6, insbesondere die Metallplatte, dünne Röhren, durch die im Betrieb eine Flüssigkeit wie Wasser fließt oder gepumpt wird. Die Wärmesenke 6 stellt dann einen Mikrokanalkühler dar.

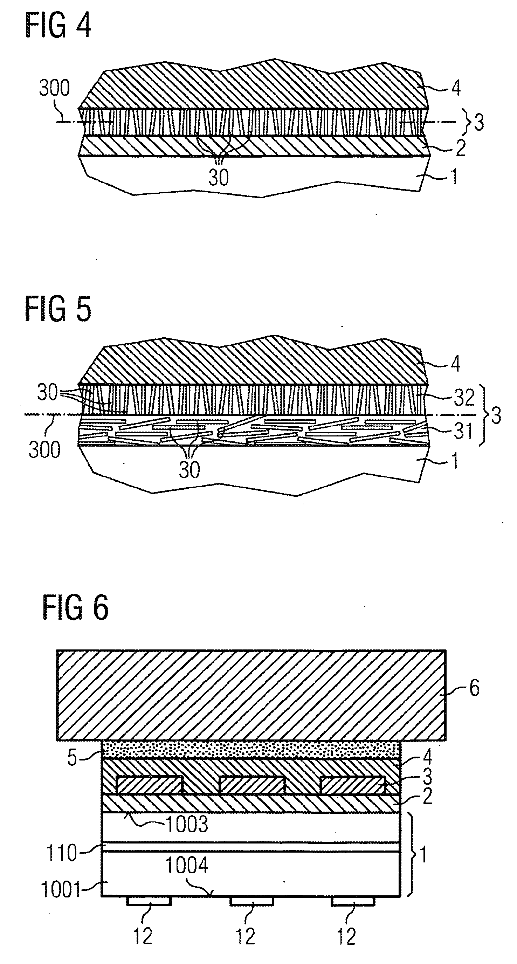

Ein Ausschnitt der Wärmeleitschicht 3 ist schematisch in Figur 4 dargestellt. Die in der Wärmeleitschicht 3 enthaltenen Kohlenstoff-Nanoröhren 30 sind senkrecht oder nahezu senkrecht zu der Haupterstreckungsebene 300 der Wärmeleitschicht 3 angeordnet. Mit anderen Worten verlaufen sie von der ersten metallischen Schicht 2 in Richtung zu der zweiten metallischen Schicht 4 hin und stehen im Wesentlichen senkrecht auf den einander zugewandten Hauptflächen der ersten und zweiten metallischen Schicht 2, 4.

Der Halbleiterlaser gemäß dem ersten Ausführungsbeispiel wird elektrisch gepumpt. Hierzu wird die laseraktive Halbleiterschichtenfolge mittels der Wärmesenke 6 und der Kontaktschicht 12, die auf der von der Wärmesenke 6 abgewandten Hauptfläche 1004 der laseraktiven Halbleiterschichtenfolge 1 in Streifenform aufgebracht ist, elektrisch kontaktiert und ein elektrischer Strom wird im Betrieb in die Halbleiterschichtenfolge 1 eingeprägt.

In Draufsicht auf die von der Wärmesenke 6, und damit auch von der Wärmeleitschicht 3, abgewandte Hauptfläche 1004 der laseraktiven Halbleiterschichtenfolge 1 wird Verlustwärme im Wesentlichen in dem von der Kontaktfläche 12 bedeckten Bereich der zweiten Hauptfläche 1004 erzeugt.

Dies ist in Figur 1B veranschaulicht, die eine um 90° um die Achse A-A gegenüber der Figur 1A gedrehte schematische Schnittdarstellung des Halbleiterlasers gemäß dem ersten Ausführungsbeispiel zeigt. Der Wärmestrom, angedeutet durch gestrichelte Linien 13, ist in schematischer und vereinfachter Weise in Figur 1B dargestellt.

Die Verlustwärme entsteht im Wesentlichen in dem Bereich der Halbleiterschichtenfolge 1, der von der Kontaktschicht 12 in Draufsicht auf die zweite Hauptfläche 1004 bedeckt ist. In der Wärmeleitschicht 3 wird der Wärmestrom durch die hohe Wärmeleitfähigkeit der Kohlenstoff-Nanoröhren 30 stark aufgespreizt. Anders ausgedrückt wird die, in Draufsicht auf die Hauptfläche 1004, auf einer kleinen, vorliegend streifenförmigen Fläche erzeugte Verlustwärme in der Wärmeleitschicht 3 auf eine größere Fläche verteilt. So wird sie mit Vorteil mittels der zweiten metallischen Schicht 4 und der Wärmesenke 6 besser an die Umgebung abgegeben und die aktive Schicht 110 weist im Betrieb des Halbleiterlasers vorteilhafterweise nur eine niedrige Temperatur auf.

Bei einer Variante dieses Ausführungsbeispiels umfasst die Wärmeleitschicht eine erste Schicht 31, die der laseraktiven Halbleiterschichtenfolge 1 benachbart ist und eine zweite Schicht 32, die nachfolgend auf die von der Halbleiterschichtenfolge 1 abgewandte Seite der ersten Schicht 31 angeordnet ist (vgl. Figur 5).

Die in der ersten Schicht 31 enthaltenen Kohlenstoff-Nanoröhren 30, oder zumindest ein Großteil von diesen, verlaufen im Wesentlichen parallel zur Haupterstreckungsebene 300 der Wärmeleitschicht 3. Beispielsweise hat die erste Schicht 31 dadurch eine besonders gute Wärmeleitfähigkeit parallel zur Haupterstreckungsebene 300, sodass der Wärmestrom besonders stark aufgespreizt wird.

Die in der zweiten Schicht 32 enthaltenen Kohlenstoff-Nanoröhren 30, oder zumindest ein Großteil von diesen, verlaufen dagegen im Wesentlichen senkrecht zur Haupterstreckungsebene 300 der Wärmeleitschicht 3. Mit der zweiten Schicht 32 wird dadurch insbesondere eine besonders gute Abfuhr der Verlustwärme von dem Halbleiterschichtstapel 1, an den die Wärmeleitschicht 3 bei dieser Variante beispielsweise direkt angrenzt, erzielt.

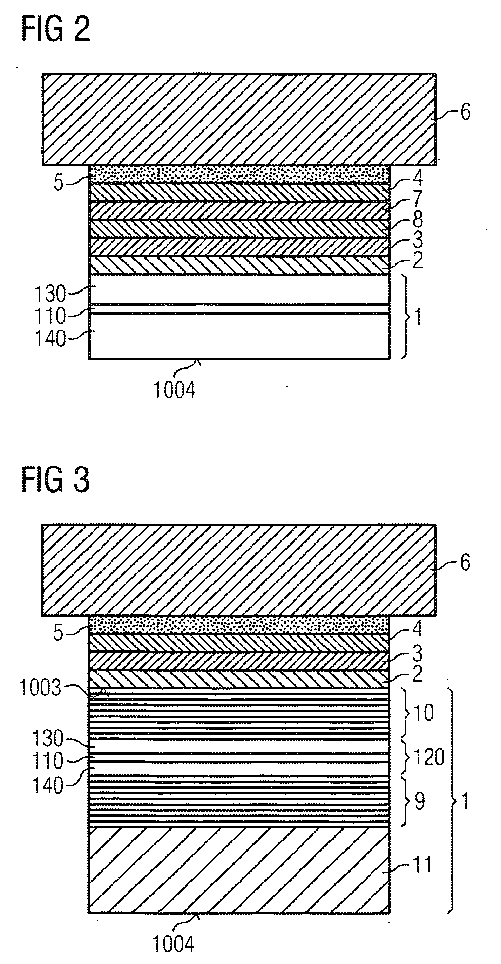

Statt einer einzelnen Wärmeleitschicht 3, die Kohlenstoff-Nanoröhren 30 enthält, weist der Halbleiterlaser gemäß dem in Figur 2 veranschaulichten Ausführungsbeispiel eine alternierende Folge von metallischen Schichten 2, 4, 8 und Wärmeleitschichten 3, 7 mit Kohlenstoff-Nanoröhren 30 auf. So wird mit Vorteil die in der laseraktiven Halbleiterschichtenfolge 1 erzeugte Wärme in Draufsicht auf die zweite Hauptfläche 1004 auf eine noch größere Fläche verteilt und noch effizienter abgeführt.

Bei dem Halbleiterlaser gemäß dem dritten Ausführungsbeispiel der Figur 3 handelt es sich im Gegensatz zu den Halbleiterlasern gemäß dem ersten und dem zweiten Ausführungsbeispiel um einen Oberflächenemitter. Die im Betrieb des Halbleiterlasers erzeugte Laserstrahlung wird durch die zweite Hauptfläche 1004 der laseraktiven Halbleiterschichtenfolge ausgekoppelt. Der Resonator des Halbleiterlasers umfasst vorliegend zwei Bragg-Reflektoren 9, 10. Die Bragg-Reflektoren 9, 10 umfassen jeweils einen Schichtstapel aus Schichten mit alternierend hohem und niedrigem Brechungsindex.

Jeder Bragg-Reflektor 9, 10 umfasst beispielsweise 28 bis 30 Perioden mit je einer GaAlAs(10%Al)-Schicht und einer GaAlAs(90%Al)-Schicht. Alternativ kann mindestens ein Bragg-Reflektor 9, 10 aus mindestens einem transparenten leitfähigen Oxid (Transparent Conducting Oxide, TCO), etwa Indium-Zinn-Oxid (Indium Tin Oxide, ITO) aufgebaut sein. Der Brechungsindex des transparenten leitfähigen Oxids ist beispielsweise mittels der Wachstumsparameter und/oder mittels eines Dotierstoffs von Schicht zu Schicht verändert. Die Haupterstreckungsebenen der Schichten der Bragg-Reflektoren 9, 10 verlaufen im Wesentlichen parallel zu der ersten und zweiten Hauptfläche 1003, 1004 der laseraktiven Halbleiterschichtenfolge 1.

Zwischen den Bragg-Reflektoren 9, 10 ist ein Teil 120 der laseraktiven Halbleiterschichtenfolge 1 angeordnet, der die aktive Schicht 110 enthält und vorzugsweise einen Wellenleiter für die von der aktiven Schicht 110 emittierte Strahlung darstellt. Beispielsweise umfasst der Wellenleiter 120 die n-Mantelschicht 130 und die p-Mantelschicht 140. Die Halbleiterschichtenfolge 1 umfasst vorliegend auch eine Halbleiterschicht 11, etwa eine Pufferschicht, die beispielsweise aus undotiertem GaAs besteht.

Der Halbleiterlaser gemäß dem vierten Ausführungsbeispiel stellt einen Laserbarren dar, dessen aktive Schicht 110 an mehreren, vorliegend drei, Stellen einen Laserstrahl von seiner Flanke 1001 emittiert. Die Stellen, von denen die Laserstrahlen emittiert werden, sind durch die Positionen der drei Kontaktschichten 12 auf der laseraktiven Halbleiterschichtenfolge 1 festgelegt (gewinngeführter Laser). Die Wärmeleitschicht 3 ist bei diesem Ausführungsbeispiel strukturiert. Sie ist in Streifen auf der ersten metallischen Schicht 2 angeordnet. Die Streifen liegen in Draufsicht auf die erste Hauptfläche 1003 der Halbleiterschichtenfolge 1 über den Stellen der aktiven Schicht 110, von denen ein Laserstrahl emittiert wird. Die zweite metallischen Schicht 4 ist auf der Wärmeleitschicht 3 und auf den von letzter nicht bedeckten Bereichen der ersten metallischen Schicht 2 angeordnet.

## Patentansprüche

1. Halbleiterlaser mit einer laseraktiven Halbleiterschichtenfolge (1), die eine erste Hauptfläche (1003) aufweist, auf der eine Wärmeleitschicht (3) angeordnet ist, die Kohlenstoff-Nanoröhren (30) enthält,
**dadurch gekennzeichnet,**
**dass** zwischen der laseraktiven Halbleiterschichtenfolge (1) und der Wärmeleitschicht (3) eine metallische Schicht (2) angeordnet ist.

2. Halbleiterlaser nach Anspruch 1, bei dem zumindest einige der Kohlenstoff-Nanoröhren (30) auf mindestens einer Seite geschlossen sind.

3. Halbleiterlaser nach einem der vorhergehenden Ansprüche, bei dem zumindest einige der Kohlenstoff-Nanoröhren (30) teilweise oder vollständig mit einem Füllmaterial gefüllt sind.

4. Halbleiterlaser nach Anspruch 3, bei dem das Füllmaterial ausgewählt ist aus der Gruppe, die Silber, Blei und die Edelgase umfasst.

5. Halbleiterlaser nach einem der vorhergehenden Ansprüche, bei dem zumindest einige der Kohlenstoff-Nanoröhren (30) einwandig sind.

6. Halbleiterlaser nach einem der vorhergehenden Ansprüche, bei dem zumindest einige der Kohlenstoff-Nanoröhren (30) mehrwandig sind.

7. Halbleiterlaser nach einem der vorhergehenden Ansprüche, mit einer ersten Mehrzahl von Kohlenstoff-Nanoröhren (30), die parallel zueinander ausgerichtet sind.

8. Halbleiterlaser nach Anspruch 7, bei dem die erste Mehrzahl von Kohlenstoff-Nanoröhren (30) parallel zur Haupterstreckungsebene der Wärmeleitschicht (3) verläuft.

9. Halbleiterlaser nach Anspruch 7, bei dem die erste Mehrzahl von Kohlenstoff-Nanoröhren (30) in einem Winkel, insbesondere senkrecht, zur Haupterstreckungsebene der Wärmeleitschicht (3) verläuft.

10. Halbleiterlaser nach einem der Ansprüche 7 bis 9 mit einer zweiten Mehrzahl von Kohlenstoff-Nanoröhren (30), die parallel zueinander und in einem Winkel zu der Richtung ausgerichtet sind, entlang welcher die ersten Mehrzahl von Kohlenstoff-Nanoröhren (30) verläuft.

11. Halbleiterlaser nach Anspruch 10, bei dem die zweite Mehrzahl von Kohlenstoff-Nanoröhren (30) parallel zur Haupterstreckungsebene der laseraktiven Halbeiterschichtenfolge (1) verläuft.

12. Halbleiterlaser nach Anspruch 10, bei dem die zweite Mehrzahl von Kohlenstoff-Nanoröhren (30) in einem Winkel, insbesondere senkrecht, zur Haupterstreckungsebene der laseraktiven Halbeiterschichtenfolge (1) verläuft.

13. Halbleiterlaser nach einem der Ansprüche 10 bis 12, bei dem die Wärmeleitschicht (3) eine erste Schicht (31) enthält, die die erste Mehrzahl von Kohlenstoff-Nanoröhren (30) aufweist, und eine zweite Schicht (32), die die zweite Mehrzahl von Kohlenstoff-Nanoröhren (30) aufweist, wobei die erste und die zweite Schicht insbesondere aneinander angrenzen.

14. Halbleiterlaser nach Anspruch 13, bei dem die erste Schicht (31) die zweite Mehrzahl von Kohlenstoff-Nanoröhren (30) nicht aufweist und/oder die zweite Schicht (32) die erste Mehrzahl von Kohlenstoff-Nanoröhren (30) nicht aufweist.

15. Halbleiterlaser nach einem der vorhergehenden Ansprüche, bei dem die Wärmeleitschicht (3) eine Schichtdicke aufweist, die einer Länge der Kohlenstoff-Nanoröhren (30) oder einem ganzzahligen Vielfachen der Länge entspricht.

16. Halbleiterlaser nach einem der vorhergehenden Ansprüche, bei dem die Wärmeleitschicht (3) strukturiert ist.

17. Halbleiterlaser nach einem der vorhergehenden Ansprüche, bei dem die Wärmeleitschicht (3) elektrisch leitfähig ist.

18. Halbleiterlaser nach einem der vorhergehenden Ansprüche, bei dem die metallische Schicht (2) eine Schichtdicke von kleiner oder gleich 10 µm hat.

19. Halbleiterlaser nach einem der vorhergehenden Ansprüche, bei dem die Wärmeleitschicht (3) an die metallische Schicht (2) angrenzt.

20. Halbleiterlaser mit einer Mehrzahl von Wärmeleitschichten (3, 7), die Kohlenstoff-Nanoröhren (30) aufweisen, nach einem der vorhergehenden Ansprüche.

21. Halbleiterlaser nach Anspruch 20 mit einer alternierenden Folge von metallischen Schichten (2, 4, 8) und Wärmeleitschichten (3, 7), die Kohlenstoff-Nanoröhren (30) aufweisen.

22. Halbleiterlaser nach einem der vorhergehenden Ansprüche, der eine Wärmesenke (6) aufweist.

23. Halbleiterlaser nach Anspruch 22, bei dem die Wärmeleitschicht beziehungsweise die Wärmeleitschichten (3, 7) zwischen der Halbleiterschichtenfolge (1) und der Wärmesenke (6) angeordnet ist/sind.

24. Halbleiterlaser nach Anspruch 22 oder 23, bei dem die laseraktive Halbleiterschichtenfolge (1) mittels einer Befestigungsschicht(5) mit der Wärmesenke (6) mechanisch stabil verbunden ist.

25. Halbleiterlaser nach Anspruch 24, bei dem die Befestigungsschicht (5) ein Lot oder einen Klebstoff umfasst.

26. Halbleiterlaser nach einem der vorhergehenden Ansprüche, der mindestens einen Bragg-Reflektor aufweist.

27. Verfahren zum Herstellen eines Halbleiterlasers mit den Schritten:
- Bereitstellen einer laseraktiven Halbleiterschichtenfolge (1)
- Herstellen einer Wärmeleitschicht (3), die Kohlenstoff-Nanoröhren (30) aufweist, auf der laseraktiven Halbleiterschichtenfolge (1),
wobei die Wärmeleitschicht (3) auf einer metallischen Schicht (2) hergestellt wird, die auf der laseraktiven Halbleiterschichtenfolge (1) angeordnet ist.

28. Verfahren nach Anspruch 27 bei dem das Herstellen der Wärmeleitschicht (3) eine chemische Gasphasenabscheidung (chemical vapor deposition) umfasst.

29. Verfahren nach einem der Ansprüche 27 und 28, bei dem die Herstellung der Wärmeleitschicht (3) bei einer Temperatur von kleiner oder gleich 350°C erfolgt.

## Claims

1. A semiconductor laser with a laser-active semiconductor layer sequence (1) which comprises a first main face (1003) on which is arranged a heat conducting layer (3) which contains carbon nanotubes (30),
**characterised in that**
a metallic layer (2) is arranged between the laser-active semiconductor layer sequence (1) and the heat conducting layer (3).

2. A semiconductor laser according to claim 1, in which at least some of the carbon nanotubes (30) are closed at at least one side.

3. A semiconductor laser according to either of the preceding claims, in which at least some of the carbon nanotubes (30) are partially or completely filled with a filler material.

4. A semiconductor laser according to claim 3, in which the filler material is selected from the group comprising silver, lead and the noble gases.

5. A semiconductor laser according to any one of the preceding claims, in which at least some of the carbon nanotubes (30) are single-walled.

6. A semiconductor laser according to any one of the preceding claims, in which at least some of the carbon nanotubes (30) are multi-walled.

7. A semiconductor laser according to any one of the preceding claims, having a first plurality of carbon nanotubes (30) which are oriented parallel to one another.

8. A semiconductor laser according to claim 7, in which the first plurality of carbon nanotubes (30) extends parallel to the main plane of extension of the heat conducting layer (3).

9. A semiconductor laser according to claim 7, in which the first plurality of carbon nanotubes (30) extends at an angle, in particular perpendicularly, to the main plane of extension of the heat conducting layer (3).

10. A semiconductor laser according to any one of claims 7 to 9 having a second plurality of carbon nanotubes (30), which are oriented parallel to one another and at an angle to the direction along which the first plurality of carbon nanotubes (30) extends.

11. A semiconductor laser according to claim 10, in which the second plurality of carbon nanotubes (30) extends parallel to the main plane of extension of the laser-active semiconductor layer sequence (1).

12. A semiconductor laser according claim 10, in which the second plurality of carbon nanotubes (30) extends at an angle, in particular perpendicularly, to the main plane of extension of the laser-active semiconductor layer sequence (1).

13. A semiconductor laser according to any one of claims 10 to 12, in which the heat conducting layer (3) contains a first layer (31) which comprises the first plurality of carbon nanotubes (30) and a second layer (32) which comprises the second plurality of carbon nanotubes (30), the first and the second layers in particular adjoining one another.

14. A semiconductor laser according to claim 13, in which the first layer (31) does not comprise the second plurality of carbon nanotubes (30) and/or the second layer (32) does not comprise the first plurality of carbon nanotubes (30).

15. A semiconductor laser according to any one of the preceding claims, in which the heat conducting layer (3) has a layer thickness which corresponds to a length of the carbon nanotubes (30) or to an integral multiple of the length.

16. A semiconductor laser according to any one of the preceding claims, in which the heat conducting layer (3) is structured.

17. A semiconductor laser according to any one of the preceding claims, in which the heat conducting layer (3) is electrically conductive.

18. A semiconductor laser according to any one of the preceding claims, in which the metallic layer (2) has a layer thickness of less than or equal to 10 µm.

19. A semiconductor laser according to any one of the preceding claims, in which the heat conducting layer (3) adjoins the metallic layer (2).

20. A semiconductor laser having a plurality of heat conducting layers (3, 7) which comprise carbon nanotubes (30) according to any one of the preceding claims.

21. A semiconductor laser according to claim 20 having an alternating sequence of metallic layers (2, 4, 8) and heat conducting layers (3, 7) which comprise carbon nanotubes (30).

22. A semiconductor laser according to any one of the preceding claims which comprises a heat sink (6).

23. A semiconductor laser according to claim 22, in which the heat conducting layer or the heat conducting layers (3, 7) is/are arranged between the semiconductor layer sequence (1) and the heat sink (6).

24. A semiconductor laser according to claim 22 or 23, in which the laser-active semiconductor layer sequence (1) is connected in mechanically stable manner to the heat sink (6) by means of a fixing layer (5).

25. A semiconductor laser according to claim 24, in which the fixing layer (5) comprises a solder or an adhesive.

26. A semiconductor laser according to any one of the preceding claims which comprises at least one Bragg reflector.

27. A method for producing a semiconductor laser comprising the steps:
- provision of a laser-active semiconductor layer sequence (1)
- production of a heat conducting layer (3) which comprises carbon nanotubes (30) on the laser-active semiconductor layer sequence (1),
the heat conducting layer (3) being produced on a metallic layer (2) which is arranged on the laser-active semiconductor layer sequence (1).

28. A method according to claim 27, in which production of the heat conducting layer (3) involves chemical vapour deposition.

29. A method according to one of claims 27 and 28, in which production of the heat conducting layer (3) proceeds at a temperature of less than or equal to 350°C.

## Revendications

1. Laser semi-conducteur avec une succession de couches semi-conductrices (1) actives du laser, qui présente une première surface principale (1003) sur laquelle est disposée une couche thermo-conductrice (3), qui contient des nanotubes en carbone (30), **caractérisé en ce qu'**une couche métallique (2) est disposée entre la succession de couches semi-conductrices (1) actives du laser et la couche thermo-conductrice (3).

2. Laser semi-conducteur selon la revendication 1, dans lequel au moins quelques-uns des nanotubes en carbone (30) sont fermés au moins d'un côté.

3. Laser semi-conducteur selon l'une quelconque des revendications précédentes, dans lequel au moins quelques-uns des nanotubes en carbone (30) sont remplis partiellement ou complètement d'un matériau de remplissage.

4. Laser semi-conducteur selon la revendication 3, dans lequel le matériau de remplissage est choisi dans le groupe comprenant l'argent, le plomb et les gaz nobles.

5. Laser semi-conducteur selon l'une quelconque des revendications précédentes, dans lequel au moins quelques-uns des nanotubes en carbone (30) sont à simple paroi.

6. Laser semi-conducteur selon l'une quelconque des revendications précédentes, dans lequel au moins quelques-uns des nanotubes en carbone (30) sont à paroi multiple.

7. Laser semi-conducteur selon l'une quelconque des revendications précédentes, avec une première pluralité de nanotubes en carbone (30) qui sont disposés parallèlement l'un par rapport à l'autre.

8. Laser semi-conducteur selon la revendication 7, dans lequel la première pluralité de nanotubes en carbone (30) s'étend parallèlement au plan de projection principal de la couche thermo-conductrice (3).

9. Laser semi-conducteur selon la revendication 7, dans lequel la première pluralité de nanotubes en carbone (30) s'étend sous un angle, en particulier perpendiculairement, par rapport au plan de projection principal de la couche thermo-conductrice (3).

10. Laser semi-conducteur selon l'une quelconque des revendications 7 à 9 avec une deuxième pluralité de nanotubes en carbone (30), qui sont disposés parallèlement l'un à l'autre et sous un angle par rapport au sens le long duquel la première pluralité de nanotubes en carbone (30) s'étend.

11. Laser semi-conducteur selon la revendication 10, dans lequel la deuxième pluralité de nanotubes en carbone (30) s'étend parallèlement au plan de projection principal de la succession de couches semi-conductrices (1) actives du laser.

12. Laser semi-conducteur selon la revendication 10, dans lequel la deuxième pluralité de nanotubes en carbone (30) s'étend sous un angle, en particulier perpendiculairement, par rapport au plan de projection principal de la succession de couches semi-conductrices (1) actives du laser.

13. Laser semi-conducteur selon l'une quelconque des revendications 10 à 12, dans lequel la couche thermo-conductrice (3) contient une première couche (31) qui présente la première pluralité de nanotubes en carbone (30), et une deuxième couche (32), qui présente la deuxième pluralité de nanotubes en carbone (30), la première et la deuxième couche étant en particulier adjacentes.

14. Laser semi-conducteur selon la revendication 13, dans lequel la première couche (31) ne présente pas la deuxième pluralité de nanotubes en carbone (30) et/ou la deuxième couche (32) ne présente pas la première pluralité de nanotubes en carbone (30).

15. Laser semi-conducteur selon l'une quelconque des revendications précédentes, dans lequel la couche thermo-conductrice (3) présente une épaisseur de couche qui correspond à une longueur des nanotubes en carbone (30) ou à un multiple entier de la longueur.

16. Laser semi-conducteur selon l'une quelconque des revendications précédentes, dans lequel la couche thermo-conductrice (3) est structurée.

17. Laser semi-conducteur selon l'une quelconque des revendications précédentes, dans lequel la couche thermo-conductrice (3) est électriquement conductrice.

18. Laser semi-conducteur selon l'une quelconque des revendications précédentes, dans lequel la couche métallique (2) présente une épaisseur de couche inférieure ou égale à 10 µm.

19. Laser semi-conducteur selon l'une quelconque des revendications précédentes, dans lequel la couche thermo-conductrice (3) est adjacente à la couche métallique (2).

20. Laser semi-conducteur avec une pluralité de couches thermo-conductrices (3, 7), qui présentent des nanotubes en carbone (30) selon l'une quelconque des revendications précédentes.

21. Laser semi-conducteur selon la revendication 20 avec une succession alternante de couches métalliques (2, 4, 8) et de couches thermo-conductrices (3, 7), qui présentent les nanotubes en carbone (30).

22. Laser semi-conducteur selon l'une quelconque des revendications précédentes, qui présente un puits thermique (6).

23. Laser semi-conducteur selon la revendication 22, dans lequel la couche thermo-conductrice ou les couches thermo-conductrices (3, 7) est/sont disposée(s) entre la succession des couches semi-conductrices (1) et le puits thermique (6).

24. Laser semi-conducteur selon la revendication 22 ou 23, dans lequel la succession de couches semi-conductrices (1) actives du laser est reliée au moyen d'une couche de fixation (5) avec le puits thermique (6) de manière mécaniquement stable.

25. Laser semi-conducteur selon la revendication 24, dans lequel la couche de fixation (5) comprend un brasage ou un adhésif.

26. Laser semi-conducteur selon l'une quelconque des revendications précédentes, qui présente au moins un réflecteur de Bragg.

27. Procédé pour la réalisation d'un laser semi-conducteur, comprenant les étapes :
- préparation d'une succession de couches semi-conductrices (1) actives du laser
- réalisation d'une couche thermo-conductrice (3) qui présente des nanotubes en carbone (30) sur la succession de couches semi-conductrices (1) actives du laser,
où la couche thermo-conductrice (3) est réalisée sur une couche métallique (2), qui est disposée sur la succession de couches semi-conductrices (1) actives du laser.

28. Procédé selon la revendication 27 dans lequel la réalisation de la couche thermo-conductrice (3) comprend un dépôt chimique en phase vapeur (chemical vapor deposition).

29. Procédé selon l'une quelconque des revendications 27 et 28, dans lequel la réalisation de la couche thermo-conductrice (3) est réalisée à une température inférieure ou égale à 350°C.
